# EUROPEAN PATENT APPLICATION

(11) **EP 3 279 941 A1**
(43) Date of publication of application: **07.02.2018**
(21) Application number: 15832679.3
(22) Date of filing: 13.08.2015
(51) Int. Cl.: H01L 27/12, H01L 21/77

(54) **ARRAY SUBSTRATE AND PREPARATION METHOD THEREFOR, AND DISPLAY DEVICE THEREOF**

(30) Priority: 30.03.2015 CN 201510145249
(71) Applicant: BOE Technology Group Co., Ltd., Beijing 100015 (CN)
(72) Inventor: LI, Quanhu, Beijing 100176 (CN); LI, Yongqian, Beijing 100176 (CN); WANG, Longyan, Beijing 100176 (CN)
(74) Representative: Fuchs Patentanwälte Partnerschaft mbB
(86) International application number: PCT/CN2015/086873
(87) International publication number: WO 2016/155194

(57) **Abstract**

The embodiments of the present disclosure provide an array substrate and manufacturing method thereof, and a display device, which relates to the display technical field and can effectively reduce electrostatic discharge that occurs during the process of manufacturing the TFT array substrate to improve the yield of product. The manufacturing method of the array substrate comprises forming thin film transistors and signal lines, and further comprises forming signal line connecting lines, wherein the signal line connecting lines at least electrically connect the same type of signal lines. Prior to completion of manufacturing the last film layer in the manufacture procedure of said array substrate, the method further comprises etching via holes on the signal line connecting lines or at the positions of the signal lines which are close to the signal line connecting lines, said via holes being used for cutting off electric connections between the signal lines. It is for use in the manufacture of an array substrate and display device.

## Description

### FIELD

The present disclosure relates to the technical field of display, particularly to an array substrate and manufacturing method thereof, and a display device.

### BACKGROUND

In the process of manufacturing a thin film transistor (TFT for short) array substrate, the phenomenon of electrostatic accumulation always occurs, and due to the requirement of display, it is required to select a glass substrate with insulating property, thus the electrostatic accumulation generated during the manufacturing process cannot be eliminated. The generated electrostatic accumulation easily leads to the problem of electro-static discharge (ESD for short), causing decrease in even damage to the performance of the array substrate, thereby reducing the yield of product.

Specifically, in the process of manufacturing a thin film transistor, some manufacture procedure environments would lead to electrostatic accumulation, such as plasma-related manufacture procedures such as chemical vapor phase deposition (CVD for short), sputtering or dry etching, and so on. In addition, during the process of manufacture procedure switching or substrate transfer, electrostatic from the outside would also be generated. Since the insulating glass substrate cannot eliminate the electrostatic accumulation by itself, a clear potential difference would be formed on the conductor part of the array substrate. Once electro-static discharge occurs, the high voltage or high current generated instantaneously would cause decrease in even damage to in the performance of the semiconductor layer or metal wiring on the array substrate.

### SUMMARY

Embodiments of the present disclosure provide an array substrate and manufacturing method thereof, and a display device, which can effectively reduce electro-static discharge that occurs during the process of manufacturing a TFT array substrate and increase the yield of product.

A first aspect of the present disclosure provides a method of manufacturing an array substrate, comprising forming thin film transistors and signal lines, and forming signal line connecting lines, wherein said signal line connecting lines at least electrically connect the same type of signal lines. Prior to completion of manufacturing the last film layer in the manufacture procedure of said array substrate, said method further comprises: arranging via holes on said signal line connecting lines or at the positions of said signal lines which are close to said signal line connecting lines, said via holes being used for cutting off electric connections between said signal lines.

In an embodiment, said signal lines may comprise gate lines and data lines, said signal line connecting lines comprise gate line connecting lines and data line connecting lines; wherein at least one of said gate line connecting lines electrically connects all of the gate lines, at least one of said data line connecting lines electrically connects all of the data lines.

In an embodiment, via holes are etched on said signal line connecting lines or at the positions of said signal lines which are close to said signal line connecting lines, said via holes being used for cutting off electric connections between said signal lines, which may comprise: arranging a plurality of first via holes on said gate line connecting lines or at the positions of said gate lines which are close to said gate line connecting lines, said first via holes being used for cutting off electric connections between said gate lines; arranging a plurality of second via holes on said data line connecting lines or at the positions of said data lines which are close to said data line connecting lines, said second via holes being used for cutting off electric connections between said data lines.

In another embodiment, the number of said gate line connecting lines may be two. They are located in a peripheral area at two sides of a display area, respectively and are both electrically connected to the gate lines. The number of said data line connecting lines may be two. They are located in a peripheral area at two sides of the display area, respectively and are both electrically connected to the data lines.

In a further embodiment, said gate line connecting lines and said data line connecting lines may be formed by the same patterning process as said gate lines; or, said gate line connecting lines and said data line connecting lines may be formed by the same patterning process as said data lines; or, said gate line connecting lines are formed by the same patterning process as said gate lines, said data line connecting lines are formed by the same patterning process as said data lines.

In yet another embodiment, said method further comprises electrically connecting said gate line connecting lines to said data line connecting lines.

In an additional embodiment, an insulating material may be etched by dry etching, and a metal material may be etched by wet etching.

A second aspect of the present disclosure provides an array substrate comprising thin film transistors, signal lines, and signal line connecting lines, said signal line connecting lines at least electrically connecting the same type of signal lines; wherein a plurality of via holes are arranged on said signal line connecting lines or at the positions of said signal lines which are close to said signal line connecting lines, said via holes being used for cutting off electric connections between said signal lines.

In an embodiment, said signal lines may comprise gate lines and data lines, said signal line connecting lines may comprise gate line connecting lines and data line connecting lines, said gate line connecting lines electrically connect all of the gate lines, and said data line connecting lines electrically connect all of the data lines; wherein a plurality of via holes are arranged on said signal line connecting lines or at the positions of said signal lines which are close to said signal line connecting lines, said via holes being used for cutting off electric connections between said signal lines, comprising: arranging a plurality of first via holes on said gate line connecting lines or at the positions of said gate lines which are close to said gate line connecting lines, said first via holes being used for cutting off electric connections between said gate lines; arranging a plurality of second via holes on said data line connecting lines or at the positions of said data lines which are close to said data line connecting lines, said second via holes being used for cutting off electric connections between said data lines.

In another embodiment, the number of said gate line connecting lines may be two and they are located in a peripheral area at two sides of a display area, respectively; wherein said first via holes are used for cutting off electric connections between said gate lines connected via each gate line connecting line; the number of said data line connecting lines is two and they are located in a peripheral area at two sides of the display area, respectively; wherein said second via holes are used for cutting off electric connections between said data lines connected via each data line connecting line.

In yet another example, said gate line connecting lines and said data line connecting lines may be arranged in the same layer as said gate lines; or, said gate line connecting lines and said data line connecting lines may be arranged in the same layer as said data lines; or, said gate line connecting lines are arranged in the same layer as said gate lines, said data line connecting lines are arranged in the same layer as said data lines.

In an additional embodiment, said gate line connecting lines may be electrically connected to said data line connecting lines.

A third aspect of the present disclosure provides a display device comprising the above array substrate.

The embodiments of the present disclosure provide an array substrate and manufacturing method thereof, and a display device, wherein as along as charges aggregate on the signal lines, the aggregate charges can be dispersed by said signal line connecting lines to all of the signal lines connected thereto. In this way, although a potential difference would be produced between the unconnected signal lines, there would not be the situation that electro-static discharge occurs due to a large potential difference between a certain signal line and other unconnected signal lines which results from charge aggregation on said signal line. Therefore, the embodiments of the present disclosure can effectively reduce electro-static discharge that occurs during the process of manufacturing the TFT array substrate and increase the yield of product.

### BRIEF DESCRIPTION OF DRAWINGS

To set forth the technical solutions in the embodiments of the present disclosure or the prior arts more clearly, the figures needed for describing the embodiments or the prior arts are simply introduced as follows. Obviously, the figures described as follows are just some embodiments of the present disclosure. Those ordinarily skilled in the art can further obtain other figures according to these figures without spending any inventive effort.
Fig 1 is a structural schematic diagram of a connection between signal line connecting lines and signal lines as provided by an embodiment of the present disclosure.
Fig 2 is a structural schematic diagram of a connection between signal line connecting lines and signal lines as provided by another embodiment of the present disclosure.
Fig 3 is a structural schematic diagram of a connection between signal line connecting lines and signal lines as provided by a further embodiment of the present disclosure.
Fig 4 is a flow schematic diagram of manufacturing an array substrate as provided by the embodiments of the present disclosure.
Fig 5 is a process schematic diagram of manufacturing an array substrate as provided by an embodiment of the present disclosure.
Fig 6a is a sectional schematic diagram along AA' in Fig 5.
Fig 6b is a sectional schematic diagram along BB' in Fig 5.
Fig 7 is a process schematic diagram of manufacturing an array substrate as provided another embodiment of the present disclosure.
Fig 8 is a process schematic diagram of etching the data line connecting lines in the case of that insulating layers of multilayer structure above the data line connecting lines are comprised as provided by the embodiments of the present disclosure.

### Reference signs:

01-display area; 02-peripheral area; 10-gate line; 11-gate line connecting line; 20-data line; 21-data line connecting line; 30-gate insulating layer; 31-third via hole; 40-first protective layer; 41-fourth via hole; 50-first via hole; 60-second via hole.

### DETAILED DESCRIPTION

The technical solutions in the embodiments of the present disclosure are described clearly and comprehensively as follows in combination with the figures in the embodiments of the present disclosure. Obviously, the described embodiments are just a part of the embodiments of the present disclosure rather than all of them. On the basis of the embodiments in the present disclosure, all other embodiments obtained by those ordinarily skilled in art without spending inventive efforts pertain to the protection scope of the present disclosure.

The embodiments of the present disclosure provide a method of manufacturing an array substrate, comprising forming thin film transistors and signal lines, and forming signal line connecting lines, wherein said signal line connecting lines at least electrically connect the same type of signal lines. Prior to completion of manufacturing the last film layer in the manufacture procedure of said array substrate, said method further comprises: arranging via holes on said signal line connecting lines or at the positions of said signal lines which are close to said signal line connecting lines, said via holes being used for cutting off electric connections between said signal lines.

It should be noted that, firstly, the type of the signal lines is not defined, as along as they are signal lines formed on the array substrate and are likely to generate electro-static discharge with other conductors. For example, the signal lines may be gate lines, or data lines, or common electrode lines, etc.

The embodiments of the present disclosure take a type of signal lines that perform the same function as the same type of signal lines. For examples, all gate lines are called the same type of signal lines, and all data lines are called the same type of signal lines.

Secondly, said signal lines and said signal line connecting lines may be directly connected and may also be indirectly connected, which is not specifically defined.

The positions where the signal line connecting lines are formed are not defined. They can be formed in the display area and may also be formed in the peripheral area. When they are formed in the peripheral area, if the signal lines to which they are connected are located in the display area, the signal lines can be extended to the peripheral area such that they can be connected to the signal line connecting lines located in the peripheral area.

Thirdly, the time point where the process of cutting off electric connections between the signal lines connected via the signal line connecting lines is performed is not specifically defined. During the process from forming the signal line connecting lines and electrically connecting the signal line connecting lines to the signal lines to completing the last film layer of the array substrate, it is possible to select a suitable time point to perform the above cutoff operation in comprehensive consideration of the factors such as the process of the cutoff operation and that even if electrostatic would be introduced after the cutoff, the electrostatic would not cause electro-static discharge to be generated between the signal lines. Here, the last film layer manufactured for the array substrate may be an orientation layer.

The operation of cutting off electric connections between the signal lines, for example, may be: at a predetermined position of the signal line connecting line or signal line, etching, by wet or dry etching, the signal line connecting line or signal line at the predetermined position so as to enable the originally unconnected signal lines to be no longer electrically connected. Namely, a via hole is etched by wet or dry etching at a predetermined position of the signal line connecting line or signal line, which cuts off the electric connection between the signal lines connected together via the signal line connecting lines.

In an example, in the case that the signal line and signal line connecting line are formed and they have been electrically connected, an insulating layer is further formed above them. Due to the presence of the insulating layer, even if electrostatic is introduced subsequently, electro-static discharge would not occur on the signal line because of accumulation of large charges. Thus, the cutoff operation can be performed after the above insulating layer has been formed.

Since the array substrate comprises different types of signal lines, whereas each type of signal lines is likely to generate electro-static discharge with other conductors, the embodiments of the present application can perform the above cutoff operation after the different types of signal lines which are most likely to generate electro-static discharge have all been conducted by the signal line connecting lines.

Fourthly, as for etching a via hole on the signal line connecting line, it is possible to etch a via hole at a position between adjacent connecting points where the signal line connecting line is connected to the signal line, and it is also possible to etch a via hole at a position where the signal line connecting line is connected to the signal line.

The embodiments of the present disclosure provide a manufacturing method of an array substrate. As along as charges aggregate on the signal lines, the aggregate charges can be dispersed by the signal line connecting lines to all of the signal lines connected thereto. In this way, although a potential difference would be produced between the unconnected signal lines, there would not be the situation that electro-static discharge occurs due to a large potential difference between a certain signal line and other unconnected signal lines which results from charge aggregation on said signal line. Therefore, the embodiments of the present disclosure can effectively reduce electro-static discharge that occurs during the process of manufacturing the TFT array substrate and increase the yield of product.

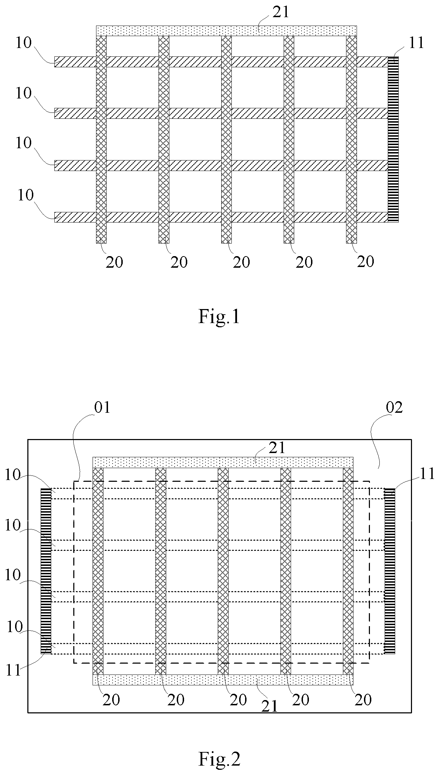

During the practical production, electro-static discharge occurs most frequently between data lines and gate lines. Therefore, the signal lines of the embodiments of the present disclosure may be the two types of signal lines, i.e., gate lines and data lines. On such basis, as shown in Figs 1-2, the signal line connecting lines comprise gate line connecting lines 11 for connecting all of gate lines 10 and data line connecting lines 21 for connecting all of data lines 20.

The number of said gate line connecting lines 11 may be at least one, and the number of said data line connecting lines 21 may also be at least one.

It should be noted that Figs 1-2 are only for explaining the connecting relation between the gate lines 10 and the gate line connecting lines 11 as well as the connecting relation between the data lines 20 and the data line connecting lines 21, which do not define the order of forming the gate lines 10 and the data lines 20, not to speak of defining the manner of connecting the gate lines 10 to the gate line connecting lines 11, and the manner of connecting the data lines 20 and the data line connecting lines 21.

In an illustrative embodiment, as shown in Fig 2, the number of the gate line connecting lines 11 is two. They are located in a peripheral area 02 at two sides of a display area 01, respectively and are both electrically connected to all of the gate lines 10. The number of the data line connecting lines 21 is two. They are located in a peripheral area 02 at two sides of the display area 01, respectively and are both electrically connected to all of the data lines 20.

Here, to enable an electric connection of the gate line connecting line 11 to the gate line 10, the gate line 10 needs to extend to the peripheral area 02. Likewise, to enable an electric connection of the data line connecting line 21 to the data line 20, the data line 20 needs to extend to the peripheral area.

With respect to the embodiment in which the number of the gate line connecting line 11 and the number of the data line connecting line 21 are both one, the gate lines 10 and the gate line connecting line 11 or the data lines 20 and the data line connecting line 21 need to be electrically connected by means of via holes in the course of manufacturing the array substrate, and in this course deficiencies in electric connections may cause some gate lines 10 and the gate line connecting line 11 or some data lines 20 and the data line connecting line 21 cannot be electrically connected. Therefore, the probability of deficiencies in electric connections can be reduced by arranging two gate line connecting lines 11 and enabling both of them to be electrically connected to the gate lines 10, and arranging two data line connecting lines 21 and enabling both of them to be electrically connected to the data lines 20. In addition, if the number of the gate line connecting lines 11 and the number of the data line connecting lines 21 are selected to be very large, they would occupy too much room of the peripheral area, causing other wiring in the peripheral area to be restricted and increasing the process difficulty.

It should be noted that the gate lines 10 being represented by dashed lines in Fig 2 indicates that they are not in the same layer as the data lines 20.

In an illustrative embodiment, at the time of forming the gate line connecting lines 11 and the data line connecting lines 21, in order to avoid increase in times of patterning process, the gate line connecting lines 11 and the data line connecting lines 21 may be manufactured by the following methods:
First Method: the gate line connecting lines 11 and the data line connecting lines 21 are formed by the same patterning process as the gate lines 10.

At that time, the gate lines 10 and the gate line connecting liens 11 are electrically connected directly. Since the data lines 20 are insulated from the gate lines 10, the data lines 20 are connected to the data line connecting lines 21 through the via holes in the insulating layer.

Second Method: the gate line connecting lines 11 and the data line connecting lines 21 are formed by the same patterning process as the data lines 20.

At that time, the data lines 20 and the data line connecting lines 21 are electrically connected directly. Since the data lines 20 are insulated from the gate lines 10, the gate lines 10 are connected to the gate line connecting lines 11 through the via holes in the insulating layer.

Third Method: the gate line connecting lines 11 are formed by the same patterning process as the gate lines 10, and the data line connecting lines 21 are formed by the same patterning process as the data lines 20.

At that time, the gate lines 10 and the gate line connecting lines 11 are electrically connected directly, and the data lines 20 and the data line connecting lines 21 are electrically connected directly.

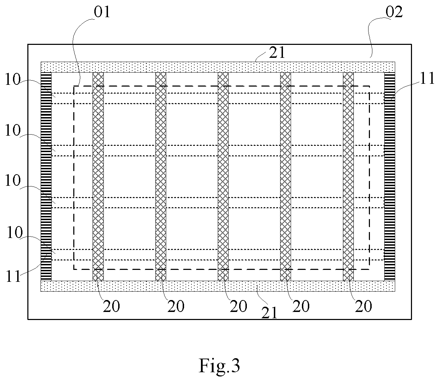

On the basis of the above, as show in Fig 3, the method further comprises: electrically connecting the gate line connecting lines 11 to the data line connecting lines 21.

In this way, the aggregate charges can be distributed on all of the gate lines 10 and all of the data lines 20 by means of the above electrically connecting relationships, forming electrostatic balance without potential difference. Therefore, the probability of occurrence of electro-static discharge can be further reduced during the process of manufacturing the TFT array substrate.

The gate line connecting lines 11 and the data line connecting lines 21 may be directly electrically connected and may also be indirectly electrically connected.

On such basis, if the number of the gate line connecting lines 11 is two and the number of the data line connecting line 21 is one, it is possible to enable both of the gate line connecting lines 11 to be electrically connected to the data line connecting line 21, and it is also possible to enable one of the gate line connecting lines 11 to be electrically connected to the data line connecting line 21.

If the number of the gate line connecting line 11 is one and the number of the data line connecting lines 21 is two, it is possible to enable both of the data line connecting lines 21 to be electrically connected to the gate line connecting line 11, and it is also possible to enable one of the data line connecting lines 21 to be electrically connected to the gate line connecting line 11.

If the number of the gate line connecting lines 11 is two and the number of the data line connecting lines 21 is also two, it is possible to enable only one of the gate line connecting lines 11 to be electrically connected to one of the data line connecting lines 21, or enable either of the two gate line connecting lines 11 to be electrically connected to either of the two data line connecting lines 21.

In addition, as regards the above first and second methods, when the gate line connecting lines 11 and the data line connecting lines 21 are formed, they are directly electrically connected. As regards the above third method, the gate line connecting lines 11 and the data line connecting lines 21 are electrically connected through the via holes in the insulating layer.

In an illustrative embodiment, regardless of forming via holes for enabling the gate lines 10 to be electrically connected to the gate line connecting lines 11 and enabling the data lines 20 to be electrically connected to the data line connecting lines 21, and via holes for enabling the gate line connecting lines 11 to be electrically connected to the data line connecting lines 21, or etching via holes on the gate line connecting lines 11 or at the positions of the gate lines 10 which are close to the gate line connecting lines 11, and etching via holes on the data line connecting lines 21 or at the positions of the data lines 20 which are close to the data line connecting lines 21, dry etching is employed as along as the insulating material is etched during the etching process, and wet etching is employed for etching the metal material.

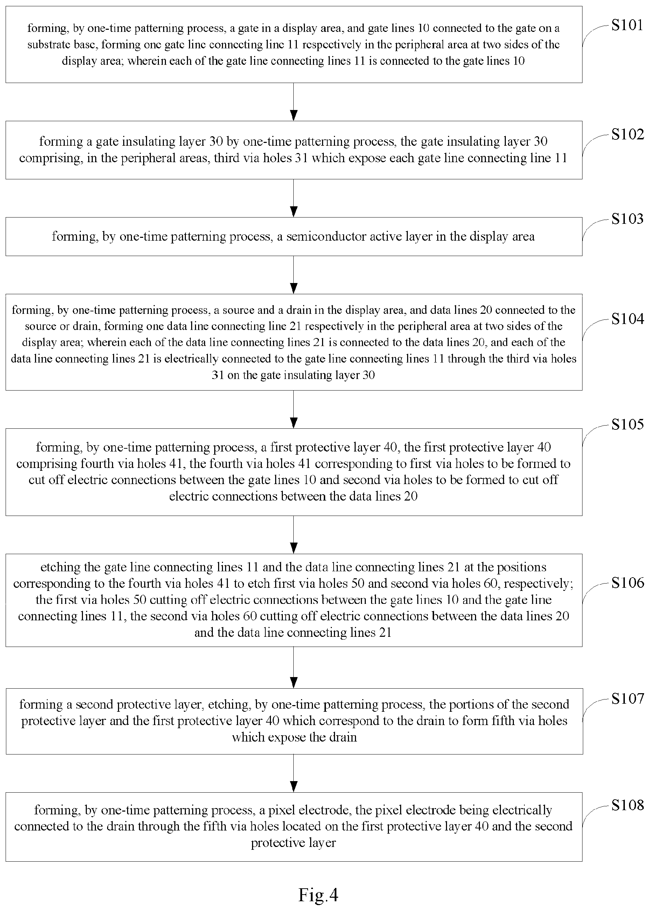

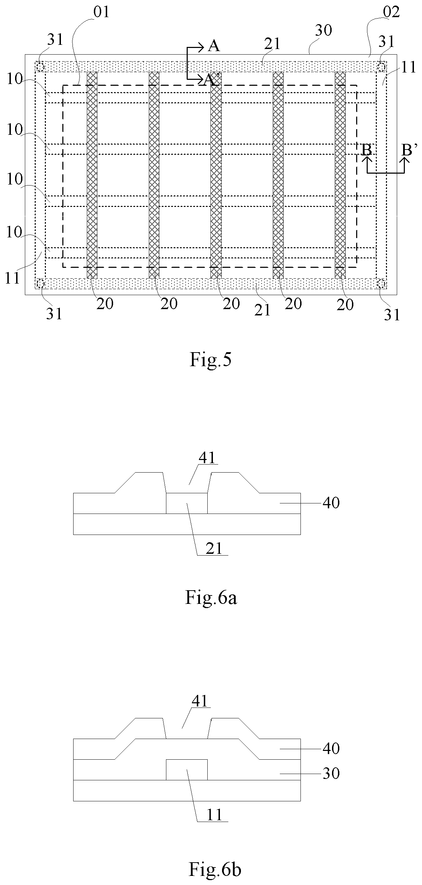

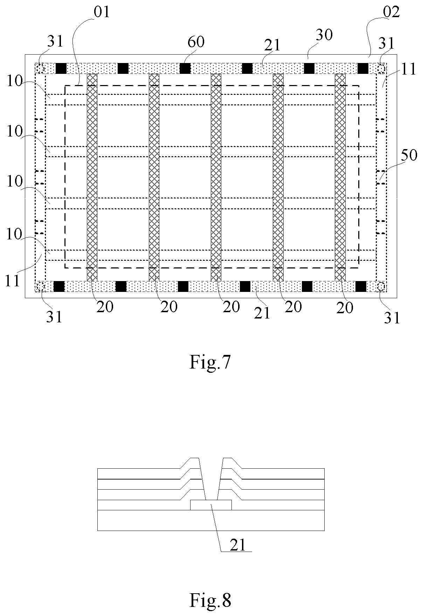

A specific embodiment is provided as follows to describe in detail the manufacturing method of the array substrate as provided by the embodiments of the present disclosure. As shown in Fig 4, the method comprises the following steps:
at S101, as shown in Fig 5, forming, by one-time patterning process, a gate (not marked in Fig 5) and gate lines 10 connected to the gate on a substrate base, forming one gate line connecting line 11 respectively in the peripheral area at two sides of the display area; wherein each of the gate line connecting lines 11 is connected to the gate lines 10;
at S102, as shown in Fig 5, on the basis of completion of S101, forming a gate insulating layer 30 by one-time patterning process, the gate insulating layer 30 comprising, in the peripheral areas, third via holes 31 which expose each gate line connecting line 11;
wherein the third via holes 31 are located at edges of two sides of each gate line connecting line 11;
the third via holes 31 are formed by dry etching;
the gate insulating layer 30 here may be a structure of one layer and may also be a structure of at least two layers, , which is not specifically limited;
at S103, on the basis of completion of S102, forming, by one-time patterning process, a semiconductor active layer (not marked in Fig 5) in the display area;
at S104, as shown in Fig 5, on the basis of completion of S103, forming, by one-time patterning process, a source and a drain (not marked in Fig 5) in the display area, and data lines 20 connected to the source or drain, forming one data line connecting line 21 respectively in the peripheral area at two sides of the display area; wherein each of the data line connecting lines 21 is connected to the data lines 20, and each of the data line connecting lines 21 is electrically connected to the gate line connecting lines 11 through the third via holes 31 on the gate insulating layer 30;
at S105, as shown in Figs 6a, 6b, on the basis of completion of S104, forming, by one-time patterning process, a first protective layer 40, the first protective layer 40 comprising fourth via holes 41, the fourth via holes 41 corresponding to first via holes to be formed to cut off electric connections between the gate lines 10 and second via holes to be formed to cut off electric connections between the data lines 20;
wherein the fourth via holes 41 are formed by drying etching;
the first protective layer 40 may be a structure of one layer and may also be a structure of at least two layers, which is not specifically limited;
at S106, as shown in Fig 7, on the basis of completion of S105, etching the gate line connecting lines 11 and the data line connecting lines 21 at the positions corresponding to the fourth via holes 41 to etch first via holes 50 and second via holes 60, respectively; the first via holes 50 cutting off electric connections between the gate lines 10, the second via holes 60 cutting off electric connections between the data lines 20;
wherein the gate line connecting lines 11 and the data line connecting lines 21 are etched by wet etching to etch first via holes 50 and second via holes 60, respectively;
referring to Fig 6b, at the time of forming the first via holes 50 by etching, it is required to first etch the portions of the gate insulating layer 30 which correspond to the first via holes 50 to form via holes and then etch the gate line connecting lines 11 to form the first via holes 50. Here, the gate insulating layer 30 is etched by drying etching;
at S107, on the basis of completion of S106, forming a second protective layer, etching, by one-time patterning process, the portions of the second protective layer and the first protective layer 40 which correspond to the drain to form fifth via holes which expose the drain;
wherein the second protective layer covers the fourth via holes 41 of the first protective layer 40;
the portions of the second protective layer and the first protective layer 40 which correspond to the drain are etched by dry etching to form fifth via holes;
at S108, on the basis of completion of S107, forming, by one-time patterning process, a pixel electrode, the pixel electrode being electrically connected to the drain through the fifth via holes located on the first protective layer 40 and the second protective layer.

In the embodiment of the present disclosure, since the electric connections between the gate line connecting lines 11 and the gate lines 10, and between the data line connecting lines 21 and the data lines 20 are cut off after the first protective layer has been formed, even if electrostatic is introduced during the process of forming the pixel electrode, due to the presence of the protective layer located above the data lines 20, large charges would not accumulate on the gate lines 10 and the data lines 20 to cause electro-static discharge.

It should be noted that the above embodiment only takes the case of cutting off the electric connections between the gate line connecting lines 11 and the gate lines 10, and between the data line connecting lines 21 and the data lines 20 after the first protective layer 40 has been formed as an example for explanation, the embodiments of the present disclosure are not limited to that. For example, as shown in Fig 8, it is possible to cut off the electric connections between the data line connecting lines 21 and the data lines 20 after forming insulating layers of multilayer structure above the data line connecting lines 21 and the data lines 20, i.e., firstly etching via holes on the insulating layers of multilayer structure above the data line connecting lines 21, then etching the data line connecting lines 21 exposed by the via holes. Certainly, cutting off the electric connections between the gate line connecting lines 11 and the gate lines 10 is performed in the same way, which is not specifically defined.

When the stacked insulating layers of multilayer structure have different materials such as silicon nitride and silicon oxide, it is required to change the etching gas to etch the insulating layers of respective materials, which is set based on the practical situation and not defined here.

The embodiments of the present disclosure further provide an array substrate comprising thin film transistors and signal lines, and signal line connecting lines; wherein a plurality of via holes are arranged on the signal line connecting lines or at the positions of the signal lines which are close to the signal line connecting lines, the via holes being used for cutting off electric connections between the signal lines.

The thin film transistor comprises a gate, a gate insulating layer, a semiconductor active layer, a source and a drain.

It should be noted that since the via holes located on the signal line connecting lines or at the positions of the signal lines which are close to the signal line connecting lines are used for cutting of the electric connections between the signal lines in the embodiments of the present disclosure, there must be an intermediate process of electrically connecting the signal lines via the signal line connecting lines in the course of forming the above array substrate, thus the problem of electro-static discharge can be solved. As for the time point where the process of cutting off the electric connections between the signal lines is performed, it is possible to select a suitable time point to perform the above cutoff operation in comprehensive consideration of the factors such as the process of the cutoff operation and that even if electrostatic would be introduced after the cutoff, the electrostatic would not cause electro-static discharge to be generated between the signal lines during the process from forming the signal line connecting lines and electrically connecting the signal line connecting lines to the signal lines to completing the last film layer of the array substrate.

The embodiments of the present disclosure provide an array substrate. Before cutting off the electric connections between the signal lines, as along as charges aggregate on the signal lines, the aggregate charges can be dispersed by the signal line connecting lines to all of the signal lines connected thereto. In this way, although a potential difference would be produced between the unconnected signal lines, there would not be the situation that electro-static discharge occurs due to a large potential difference between a certain signal line and other unconnected signal lines which results from charge aggregation on said signal line. Therefore, the embodiments of the present disclosure can effectively reduce electro-static discharge that occurs during the process of manufacturing the TFT array substrate and increase the yield of product.

During the practical production, electro-static discharge occurs most frequently between gate lines 10 and data lines 20. Therefore, the signal lines of the embodiments of the present disclosure may be the two types of signal lines, i.e., gate lines 10 and data lines 20. On such basis, the signal line connecting lines comprise gate line connecting lines 11 and data line connecting lines 21.

On such basis, referring to Fig 7, a plurality of first via holes 50 are arranged on the gate line connecting lines 11, and the first via holes 50 are used for cutting off the electric connections between the gate lines 10. A plurality of second via holes 60 are arranged on the data line connecting lines 21, and the second via holes 60 are used for cutting off the electric connections between the data lines 20.

Certainly, it is also possible to arrange a plurality of first via holes 50 at the positions of the gate lines 10 which are close to the gate line connecting lines 11 for cutting the electric connections between the gate lines 10. It is also possible to arrange a plurality of second via holes 60 at the positions of the data lines 20 which are close to the data line connecting lines 21 for cutting off the electric connections between the data lines 20.

The number of the gate line connecting lines 11 may be at least one, and the number of the data line connecting lines 21 may be at least one.

Further, as shown in Fig 7, the number of the gate line connecting lines 11 may be two. They are located in a peripheral area 02 at two sides of the display 01, respectively; wherein the first via holes 50 are used for cutting off the electric connections between the gate lines 10 connected via each gate line connecting line 11.

The number of the data line connecting lines 21 may be two. They are located in a peripheral area 02 at two sides of the display 01, respectively; wherein the second via holes 60 are used for cutting off the electric connections between the data lines 20 connected via each data line connecting line 21.

With respect to the situation in which the number of the gate line connecting line 11 and the number of the data line connecting line 21 are both one, the gate lines 10 and the gate line connecting line 11 or the data lines 20 and the data line connecting line 21 need to be electrically connected by means of via holes in the course of manufacturing the array substrate, and in this course deficiencies in electric connections may cause some gate lines 10 and the gate line connecting line 11 or some data lines 20 and the data line connecting line 21 cannot be electrically connected. Therefore, the probability of deficiencies in electric connections can be reduced by arranging two gate line connecting lines 11 and enabling both of them to be electrically connected to the gate lines 10, and arranging two data line connecting lines 21 and enabling both of them to be electrically connected to the data lines 20, thereby avoiding occurrence of electro-static discharge due to charge accumulation on a certain signal line which results from deficiencies in the electric connection. In addition, if the number of the gate line connecting lines 11 and the number of the data line connecting lines 21 are selected to be very large, they would occupy too much room of the peripheral area, causing other wiring in the peripheral area to be restricted while increasing the process difficulty.

In an illustrative embodiment, the gate line connecting lines 11 and the data line connecting lines 21 are arranged in the same layer as the gate lines 10; or, the gate line connecting lines 11 and the data line connecting lines 21 are arranged in the same layer as the data lines 20; or, the gate line connecting lines 11 are arranged in the same layer as the gate lines 10, and the data line connecting lines 21 are arranged in the same layer as the data lines 20.

In this way, even if the gate line connecting lines 11 and the data line connecting lines 21 are added on the basis of the original process, they would not result in increase in times of patterning process.

Furthermore, the array substrate may further comprise a first electrode electrically connected to the drain.

The first electrode may be a pixel electrode. On such basis, the array substrate further comprises: forming a common electrode.

As for an in-plane switch (IPS for short) array substrate, the pixel electrode and the common electrode are arranged at intervals in the same layer and are both strip electrodes. As for an advanced-super dimensional switching (ADS for short) array substrate, the pixel electrode and the common electrode are not arranged in the same layer, wherein the upper electrode is a strip electrode while the lower electrode is a plate electrode.

Certainly, the first electrode may also be an anode or cathode. On such basis, the array substrate further comprises an organic material functional layer and a cathode or anode. Namely, when the first electrode 40 is an anode, it further comprises an organic material functional layer and a cathode; when the first electrode 40 is a cathode, it further comprises an organic material functional layer and an anode.

The organic material functional layer at least comprises an electron transport layer, a light-emitting layer and a hole transport layer. To increase the efficiency of injecting the electrons and the holes into the light-emitting layer, the organic material functional layer may further comprise an electron injection layer arranged between the cathode and the electron transport layer, and a hole injection layer arranged between the anode and the hole transport layer.

Flexible display substrates can be divided into one-side light-emitting flexible display substrate and double-side light-emitting flexible display substrate in terms of different materials of the anode and the cathode. Namely, when the material of one electrode of the anode and the cathode is opaque material, the flexible display substrate is of one-side light-emitting type; when the materials of the anode and the cathode are both transparent materials, the flexible display substrate is of double-side light-emitting type.

The embodiments of the present disclosure further provide a display device comprising the above array substrate.

The above display device may specifically be a liquid crystal display device, which may be any product or component having display function such as liquid crystal display, liquid crystal television, digital photo frame, mobile phone, tablet computer, and so on. Certainly, the above display device may also be an organic electroluminescent diode display device.

The above embodiments are just specific implementations of the present disclosure, but the protection scope of the present disclosure is not limited to that. Any variations or substitutions that can be easily conceived by those skilled in the art familiar with this technical field within the technical scope revealed by the present disclosure should be covered within the protection scope of the present disclosure. Thus, the protection scope of the present disclosure should be based on the protection scope of the claims.

## Claims

1. A method of manufacturing an array substrate, comprising forming thin film transistors and signal lines, and forming signal line connecting lines, wherein said signal line connecting lines at least electrically connect the same type of signal lines;
prior to completion of manufacturing the last film layer in the manufacture procedure of said array substrate, said method further comprising: arranging via holes on said signal line connecting lines or at the positions of said signal lines which are close to said signal line connecting lines, said via holes being used for cutting off electric connections between said signal lines.

2. The method according to claim 1, wherein said signal lines comprise gate lines and data lines, said signal line connecting lines comprise gate line connecting lines and data line connecting lines;
wherein at least one of said gate line connecting lines electrically connects all of the gate lines, at least one of said data line connecting lines electrically connects all of the data lines.

3. The method according to claim 2, wherein via holes are etched on said signal line connecting lines or at the positions of said signal lines which are close to said signal line connecting lines, said via holes being used for cutting off electric connections between said signal lines, comprising:
arranging a plurality of first via holes on said gate line connecting lines or at the positions of said gate lines which are close to said gate line connecting lines, said first via holes being used for cutting off electric connections between said gate lines; arranging a plurality of second via holes on said data line connecting lines or at the positions of said data lines which are close to said data line connecting lines, said second via holes being used for cutting off electric connections between said data lines.

4. The method according to claim 2, wherein the number of said gate line connecting lines is two, which are located in a peripheral area at two sides of a display area, respectively and are both electrically connected to said gate lines;
the number of data line connecting lines is two, which are located in a peripheral area at two sides of the display area, respectively and are both electrically connected to said data lines.

5. The method according to claim 2, wherein said gate line connecting lines and said data line connecting lines are formed by the same patterning process as said gate lines;
or, said gate line connecting lines and said data line connecting lines are formed by the same patterning process as said data lines;
or, said gate line connecting lines are formed by the same patterning process as said gate lines, said data line connecting lines are formed by the same patterning process as said data lines.

6. The method according to claim 2, further comprising: electrically connecting said gate line connecting lines to said data line connecting lines.

7. The method according to any one of claims 1 to 6, wherein etching of an insulating material is performed using drying etching, and etching of a metal material is performed using wet etching.

8. An array substrate, comprising thin film transistors, signal lines, and signal line connecting lines, said signal line connecting lines at least electrically connecting the same type of signal lines;
wherein a plurality of via holes are arranged on said signal line connecting lines or at the positions of said signal lines which are close to said signal line connecting lines, said via holes being used for cutting off electric connections between said signal lines.

9. The array substrate according to claim 8, wherein said signal lines comprise gate lines and data lines, said signal line connecting lines comprise gate line connecting lines and data line connecting lines, said gate line connecting lines electrically connect all of the gate lines, said data line connecting lines electrically connect all of the data lines;
wherein a plurality of via holes are arranged on said signal line connecting lines or at the positions of said signal lines which are close to said signal line connecting lines, said via holes being used for cutting off electric connections between said signal lines, comprising:
arranging a plurality of first via holes on said gate line connecting lines or at the positions of said gate lines which are close to said gate line connecting lines, said first via holes being used for cutting off electric connections between said gate lines; arranging a plurality of second via holes on said data line connecting lines or at the positions of said data lines which are close to said data line connecting lines, said second via holes being used for cutting off electric connections between said data lines.

10. The array substrate according to claim 9, wherein the number of said gate line connecting lines is two and they are located in a peripheral area at two sides of a display area, respectively; wherein said first via holes are used for cutting off electric connections between said gate lines connected via each gate line connecting line;
the number of said data line connecting lines is two and they are located in a peripheral area at two sides of the display area, respectively; wherein said second via holes are used for cutting off electric connections between said data lines connected via each data line connecting line.

11. The array substrate according to claim 9, wherein said gate line connecting lines and said data line connecting lines are arranged in the same layer as said gate lines;
or, said gate line connecting lines and said data line connecting lines are arranged in the same layer as said data lines;
or, said gate line connecting lines are arranged in the same layer as said gate lines, said data line connecting lines are arranged in the same layer as said data lines.

12. The array substrate according to claim 9, wherein said gate line connecting lines are electrically connected to said data line connecting lines.

13. A display device comprising the array substrate according to any one of claims 8 to 12.
